# EUROPEAN PATENT APPLICATION

(11) **EP 2 555 175 A1**
(43) Date of publication of application: **06.02.2013**
(21) Application number: 11179535.7
(22) Date of filing: 31.08.2011
(51) Int. Cl.: G08B 3/10, H01L 41/00

(54) **Transducer module**

(30) Priority: 04.08.2011 TW 100127828
(71) Applicant: Chief Land Electronic Co. Ltd., Wugu Dist., New Taipei City 248 (TW)
(72) Inventor: Chuang, Tsi-Yu, 52142 Changhua County (TW); Ching, Chia-Nan, 32097 Zhongli City, Taoyuan County (TW); Liu, Bao-Zheng, 31053 Hsinchu County (TW)
(74) Representative: Karakatsanis, Georgios

(57) **Abstract**

The present invention is directed to a transducer module including a first transducer (21) and a second transducer (23). The first transducer is directly or indirectly disposed on a first plate (25A) with a first point, and the second transducer is disposed at a second point of the first transducer. In an embodiment, an inertial mass is further disposed on the second transducer.

## Description

### BACKGROUND OF THE INVENTION

### 1. FIELD OF THE INVENTION

The present invention generally relates to a transducer, and more particularly to a transducer module utilizing a transducer for generating acoustic effect and haptic feedback.

### 2. DESCRIPTION OF RELATED ART

A transducer is a device that converts one type of energy to another. A motor and an electric generator are common electromechanical transducers. The motor converts electric energy to mechanical energy via electromagnetic induction. One type of motor, such as a brush DC motor, a servo motor or a step motor, outputs the mechanical energy in rotational movement; another type of motor, such as a linear motor, converts electric energy directly to linear movement. The electric generator, on the other hand, converts mechanical energy to electric energy. A single-phase generator or a three-phase generator is commonly used in an electric power system. Moreover, the transducer may be implemented by smart material, such as piezoelectric material, electro-active polymer (EAP), shape memory alloy (SMA), magnetostrictive material or electrostrictive material.

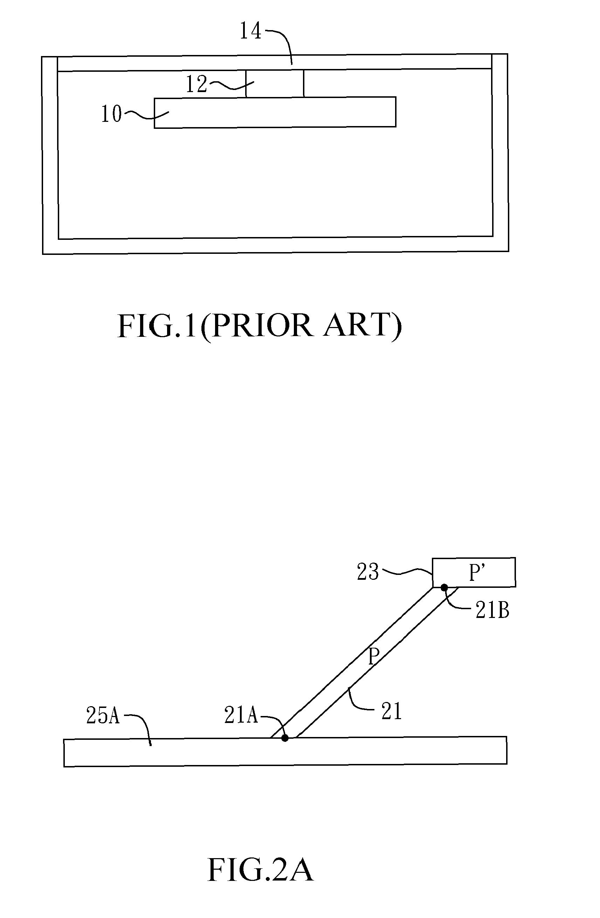

FIG. 1 shows a conventional transducer device, in which a transducer 10, such as a unimorph actuator, bimorph actuator or multimorph actuator, is made of piezoelectric material, which converts electric signals to mechanical movement via converse piezoelectric effect. A common piezoelectric plate has a rectangular shape, a round shape (as of a buzzer) or other shape, which is dependent on actual applications. Considering output strength as a performance index, the multimorph actuator is better than the bimorph actuator, which is further better than the unimorph actuator. Considering cost, as the price of the piezoelectric plate is proportional to its stacked number, the unimorph actuator takes priority if the performance is not strictly required.

The structure shown in FIG. 1 is a conventional vibration propagation device, in which the vibration energy of the transducer 10 can be transferred to a top housing 14 via a sticking element 12, thereby generating acoustic effect or haptic feedback. The transducer is ordinarily fixed, by sticking or locking, under the top housing 14 such that the vibration energy may be directly transferred to the top housing 14. However, the commonly used material of the transducer 10 limits the swing amplitude and output strength at endpoints or edges of the transducer 10, such that the transferred vibration energy is restrained, the haptic reaction of the haptic feedback is not evident or the sound pressure level (SPL) generated on the top housing 14 is low.

For the foregoing reasons, a need has arisen to propose a novel transducer module for increasing inertial force.

### SUMMARY OF THE INVENTION

In view of the foregoing, it is an object of the embodiment of the present invention to provide a transducer module, which improves acoustic propagation, haptic feedback or the assembly procedure.

According to one embodiment of the present invention, the transducer module includes a first transducer and a second transducer. Specifically, the first transducer is directly or indirectly disposed on a first plate with a first point, and the second transducer is disposed at a second point of the first transducer. In an embodiment, an inertial mass is further disposed on the second transducer. The embodiment may increase swing amplitude, enhance the transferred inertial force or adjust resonant mode.

### BRIEF DESCRIPTION OF THE DRAWINGS

FIG. 1 shows a conventional transducer device;
FIG. 2A to FIG. 2G show cross sections of some transducer modules according to embodiments of the present invention;
FIG. 3A to FIG. 3C show cross sections of some transducer modules according to embodiments of the present invention;
FIG. 4A shows a detailed cross section of a first/second transducer; and
FIG. 4B shows a detailed cross section of another first/second transducer.

### DETAILED DESCRIPTION OF THE INVENTION

FIG. 2A shows a cross section of a transducer module according to one embodiment of the present invention. In the embodiment, the transducer module is used, but not limited, to convert electric energy to mechanical energy. The transducer module of the embodiment includes a first transducer (denoted as P) 21 and a second transducer (denoted as P') 23. Specifically, the first transducer 21 is disposed on a first plate 25A with a first point 21A, and the second transducer 23 is disposed on the first transducer 21 with a second point 21B. The first transducer 21 may be insulated from the second transducer 23 by an insulator (not shown in the figure).

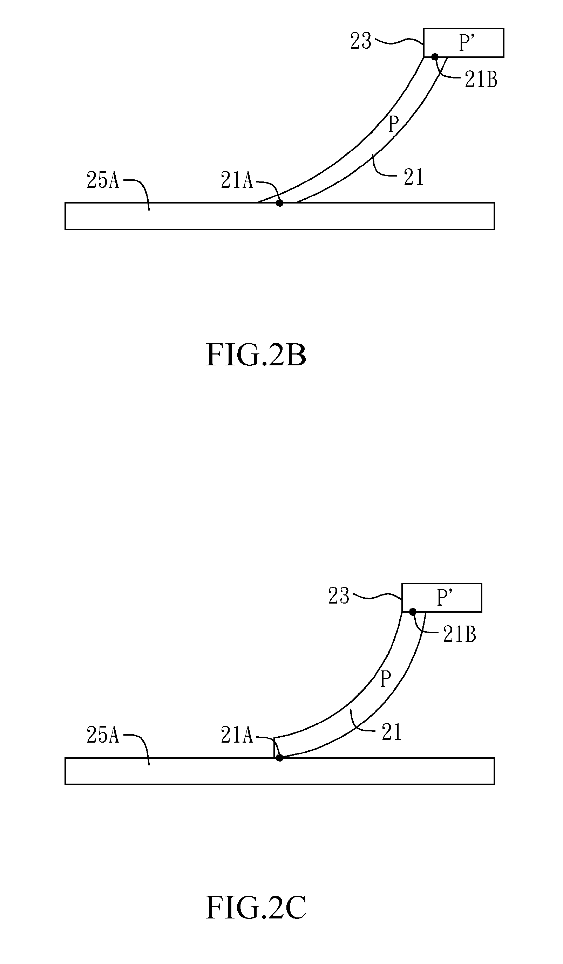

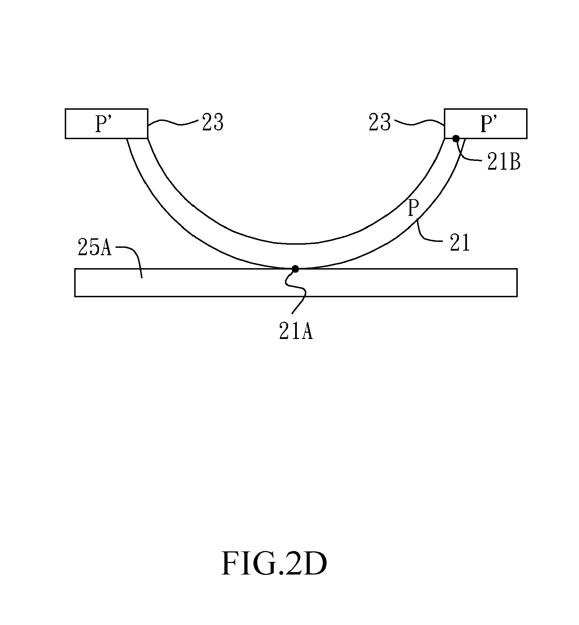

The first transducer 21 shown in FIG. 2A has a planar shape. However, other shape may be used instead. For example, FIG. 2B shows a cross section of another transducer module, in which the first transducer 21 has a curved shape. The first point 21A and the second point 21B mentioned above are, but not limited to, two endpoints of the first transducer 21. FIG. 2C, for example, shows a cross section of another transducer module, in which the first transducer 21 is disposed on the first plate 25A with a non-endpoint first point 21A. FIG. 2D shows a cross section of a further transducer module, in which the first transducer 21 is disposed on the first plate 25A with a non-endpoint (e.g., a middle point), and at least one second transducer 23 is disposed at one or more endpoints of the second transducer 23.

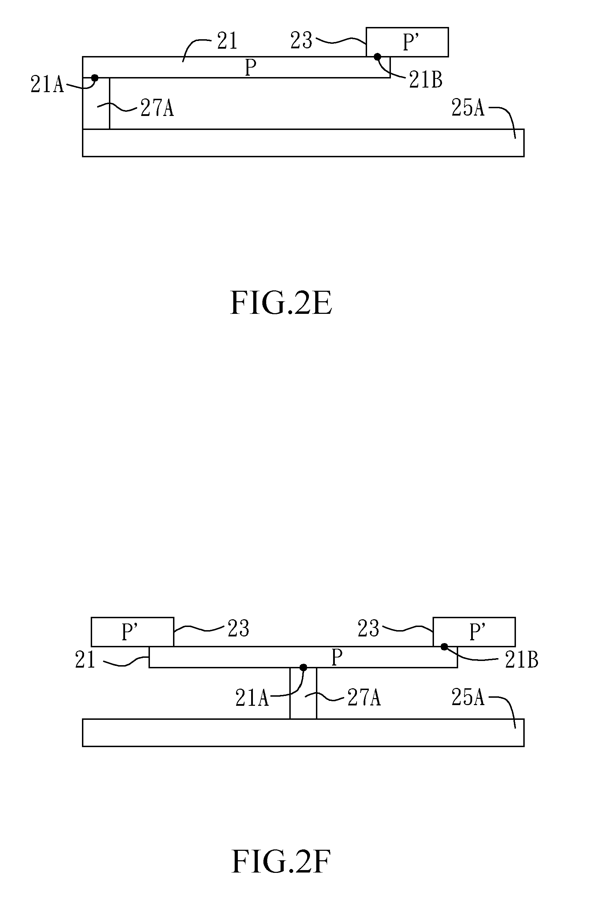

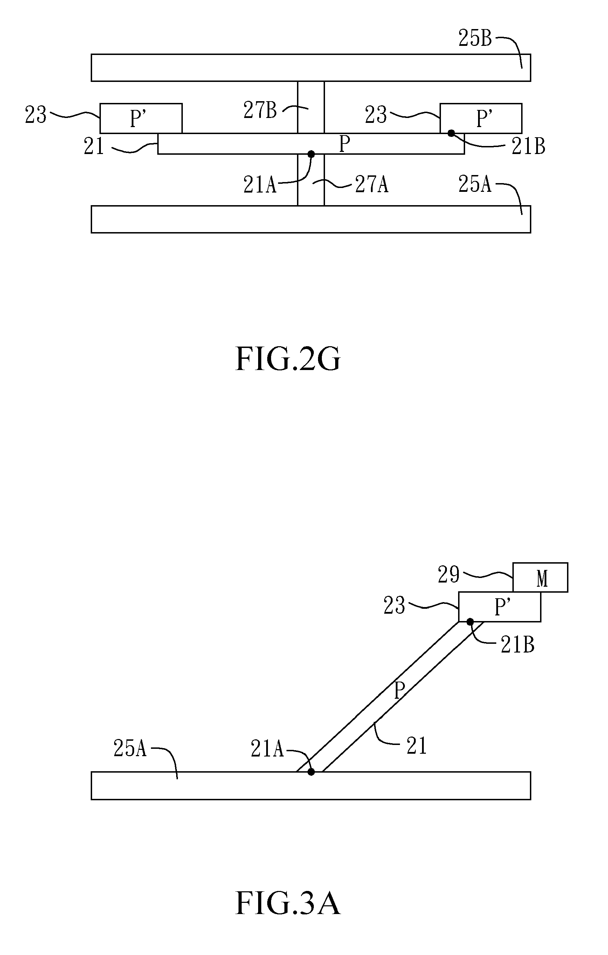

As described above, the first transducer 21 of FIG. 2A is directly disposed on the first plate 25A with the first point 21A. However, as shown in FIG. 2E, the first transducer 21 may be indirectly disposed on the first plate 25A via a first support member 27A. In other words, two ends of the first support member 27A are coupled to the first plate 25A and the first transducer 21, respectively. Similarly, as described above, the first transducer 21 of FIG. 2D is directly disposed on the first plate 25A with the non-endpoint (e.g., the middle point) first point 21A. However, as shown in FIG. 2F, the first transducer 21 may be indirectly disposed on the first plate 25A via a first support member 27A. No matter the first transducer 21 is indirectly disposed on the first plate 25A with the non-endpoint first point 21A in FIG. 2E or with the non-endpoint first point 21A in FIG. 2F, the embodiment may further include a second support member 27B and a second plate 25B as shown in FIG. 2G, wherein the two ends of the second support member 27B are coupled to the first transducer 21 and the second plate 25B, respectively.

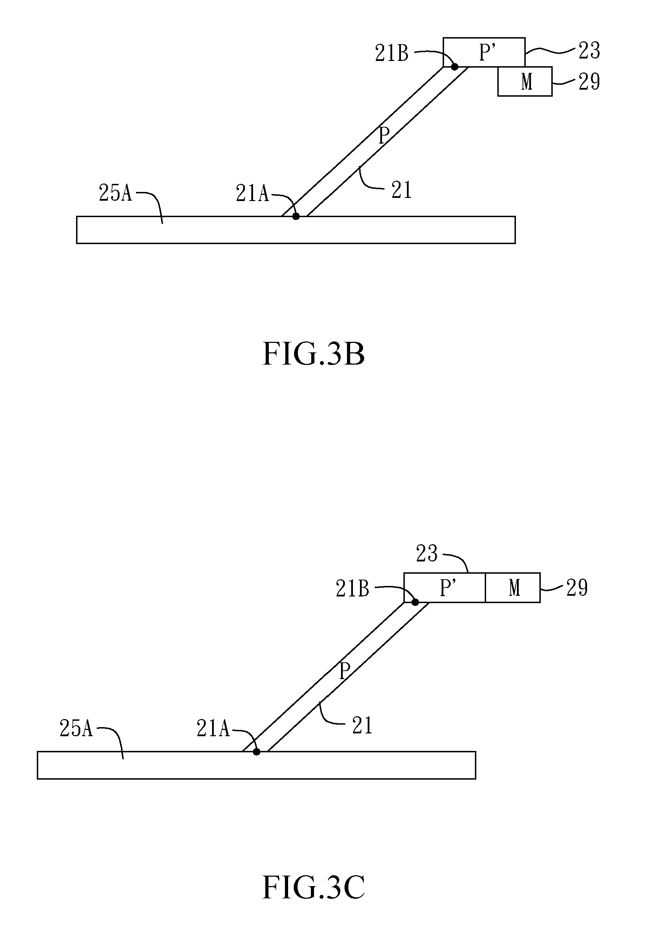

With respect to the various embodiments discussed above, at least one inertial mass (denoted as M) 29 may be disposed on the second transducer 23. Although an example adopting the structure of FIG. 2A is illustrated below, it is appreciated that FIG. 2B to FIG. 2G may be adopted as well. FIG. 3A shows a cross section of a transducer module according to one embodiment of the present invention. In the embodiment, an inertial mass 29 is disposed on a top surface of the second transducer 23. FIG. 3B shows a cross section of another transducer module of the present invention, in which an inertial mass 29 is disposed on a bottom surface of the second transducer 23. FIG. 3C shows a cross section of a further transducer module of the present invention, in which an inertial mass 29 is disposed on an edge of the second transducer 23.

According to the transducer modules of FIGs. 2A-2G and FIGs. 3A-3C, when the first transducer 21 is driven by electric energy, it generates vibration and inertial force, which are then transferred to the first plate 25A and make the first plate 25A vibrate and push the air, thereby generating acoustic effect or haptic feedback. The second transducer 23 may be selectively driven to vibrate when the first transducer 21 has been driven by electric energy. The vibration of the second transducer 23 amplifies vibration amplitude and inertial force transferred to the first plate 25A, thereby generating better acoustic effect or haptic feedback; increasing selectivity of adjusting resonant mode; or increasing swing amplitude of the first transducer 21 to enhance the transferred inertial force. The inertial mass 29 may be selectively used to enhance inertial force of the second transducer 23 or adjust resonant mode. Compared to the conventional transducer device as shown in FIG. 1, the present embodiment possesses better acoustic effect or haptic feedback. The composing elements of the transducer module of FIGs. 2A-2G and FIGs. 3A-3C will be described below.

In the embodiment, the combination of some or all composing elements may be manufactured in a module in order to speed up the assembly. For example, the combination may include the first transducer 21 and the second transducer 23, or may include the first transducer 21, the second transducer 23 and the inertial mass 29, or even the first support member 27A, the second support member 27B, the first plate 25A and/or the second plate 25B. The interconnection among the composing elements may be realized by integrally forming, sticking, locking, screwing or other techniques. The first plate 25A or the second plate 25B may be a screen, a touch sensitive plate, a frame, a substrate or a housing. The first support member 27A or the second support member 27B may be hollow or solid, may have a tube, cylindrical or other shapes, and the quantity may be one or greater than one. The inertial mass 29 may be made of a variety of materials and shapes, such as high-density material (e.g., metal) or material with high Young's modulus (e.g., zirconium oxide).

In the embodiment, the first transducer 21 may be made of smart material such as, but not limited to, piezoelectric material (e.g., lead-zirconate-titanate (PZT)), electro-active polymer (EAP), shape memory alloy (SMA) or magnetostrictive material. The second transducer 23 may be made of the same material of the first transducer 21, or is made of a voice coil motor, an eccentric rotating mass (ERM) motor or a linear resonant actuator (LRA).

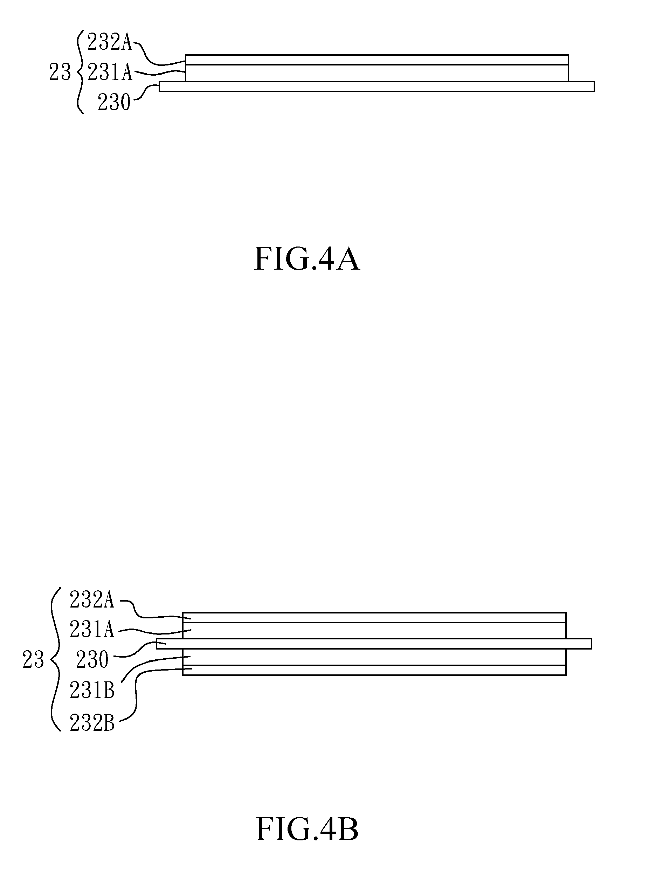

FIG. 4A shows a detailed cross section of the first transducer 21 or the second transducer 23. The second transducer 23 will be exemplified below. The second transducer 23 includes a conductive layer 230, a first smart material layer 231A and a first electrode layer 232A. Specifically, the first smart material layer 231A is formed on a top surface of the conductive layer 230, and the first electrode layer 232A is then coated on a top surface of the first smart material layer 231A. The conductive layer 230 and the first electrode layer 232A are used as two electrodes for driving the first smart material layer 231A, and the conductive layer 230, in practice, is made of thin material layer (e.g., an electrode layer) or plate-type material layer (e.g., a metal plate). A conductive layer 230 made of a metal plate can increase toughness and durability of the second transducer 23, and can increase the inertial force for generating acoustic effect or haptic feedback. If single layer of the first smart material layer 231A made of piezoelectric material is used, the second transducer 23 of FIG. 4A may be called a unimorph actuator. The second transducer 23 may, in practice, use two or more layers of the first smart material layer 231A, therefore resulting in a multi-layer actuator.

FIG. 4B shows a detailed cross section of another first transducer 21 or the second transducer 23. The second transducer 23 will be exemplified below. The second transducer 23 includes a conductive layer 230, a first smart material layer 231A, a first electrode layer 232A, a second smart material layer 231B and a second electrode layer 232B. Specifically, the first smart material layer 231A is formed on a top surface of the conductive layer 230, and the first electrode layer 232A is then coated on a top surface of the first smart material layer 231A. The second smart material layer 231B is formed on a bottom surface of the conductive layer 230, and the second electrode layer 232B is then coated on a bottom surface of the second smart material layer 231B. The conductive layer 230 is used as a common electrode for the first/second smart material layers 231A/B, and the first/second electrode layers 232A/B are used as two electrodes for driving the first/second smart material layers 231A/B. As two layers (i.e., the first and second smart material layers 231A/B) made of piezoelectric material are used, the second transducer 23 of FIG. 4B may be called a bimorph actuator. The second transducer 23 may, in practice, use two or more layers of the first/second smart material layer 231A/B on at least one side of the second transducer 23, therefore resulting in a multi-layer actuator.

Although specific embodiments have been illustrated and described, it will be appreciated by those skilled in the art that various modifications may be made without departing from the scope of the present invention, which is intended to be limited solely by the appended claims.

## Claims

1. A transducer module, comprising:
a first transducer directly or indirectly disposed on a first plate with a first point; and
a second transducer disposed at a second point of the first transducer.

2. The transducer module of claim 1, wherein the first point and the second point are two endpoints of the first transducer.

3. The transducer module of claim 1, wherein the first point is a non-endpoint of the first transducer, and the second point is an endpoint of the first transducer.

4. The transducer module of claim 1, wherein the first transducer has a planar shape.

5. The transducer module of claim 1, wherein the first transducer has a curved shape.

6. The transducer module of claim 1, further comprising a first support member disposed between the first point and the first plate.

7. The transducer module of claim 1, further comprising at least one inertial mass disposed on the second transducer.

8. The transducer module of claim 7, wherein the inertial mass is disposed on a top surface, a bottom surface or an edge of the second transducer.

9. The transducer module of claim 6, further comprising:
a second plate; and
a second support member having two ends coupled to the first transducer and the second plate respectively.

10. The transducer module of claim 9, wherein the first plate or the second plate is a screen, a touch sensitive plate, a frame, a substrate or a housing.

11. The transducer module of claim 1, wherein the first transducer is made of piezoelectric material, electro-active polymer (EAP) or shape memory alloy (SMA) or magnetostrictive material.

12. The transducer module of claim 11, wherein the piezoelectric material is lead-zirconate-titanate (PZT).

13. The transducer module of claim 1, wherein the second transducer is made of piezoelectric material, electro-active polymer (EAP), shape memory alloy (SMA), magnetostrictive material, a voice coil motor, an eccentric rotating mass (ERM) motor or a linear resonant actuator (LRA).

14. The transducer module of claim 1, wherein the first transducer or the second transducer comprises:
a conductive layer;
at least one first smart material layer, formed on a top surface of the conductive layer; and
at least one first electrode layer, formed on a top surface of the first smart material layer.

15. The transducer module of claim 14, wherein the conductive layer is a metal plate.

16. The transducer module of claim 14, wherein the first transducer or the second transducer further comprises:
at least one second smart material layer, formed on a bottom surface of the conductive layer; and
at least one second electrode layer, formed on a bottom surface of the second smart material layer.
